Europäisches Patentamt

European Patent Office

Office européen des brevets

(19)

(11) Publication number:

**0 140 600**

**B1**

(12) EUROPEAN PATENT SPECIFICATION

(45) Date of publication of patent specification: 24.08.88

(51) Int. Cl.⁴: **H 01 L 23/36**

(21) Application number: **84306790.1**

(22) Date of filing: **05.10.84**

(54) Improvements in diamond heatsink assemblies.

(30) Priority: **08.10.83 GB 8326983**

(43) Date of publication of application:
**08.05.85 Bulletin 85/19**

(45) Publication of the grant of the patent:
**24.08.88 Bulletin 88/34**

(84) Designated Contracting States:
**DE FR IT NL**

(56) References cited:
**FR-A-2 148 087**
**US-A-3 872 496**
**US-A-3 974 518**

**PATENT ABSTRACTS OF JAPAN, Vol. 5, No.
205, (E-88) (877), December 25, 1981; & JP-A-56
125 849**

(73) Proprietor: **PLESSEY OVERSEAS LIMITED
Vicarage Lane
Ilford Essex IGI 4AQ (GB)**

(72) Inventor: **Geen, Michael William
93 Water Meadow Drive
Northampton NN3 4ST (GB)**
Inventor: **Eaton, Ralph Melville
21 Mapperley Drive
Northampton (GB)**

(74) Representative: **Elliott, Frank Edward
The Plessey Company plc. Intellectual Property
Department Vicarage Lane
Ilford, Essex IG1 4AQ (GB)**

Courier Press, Leamington Spa, England.

## Description

This invention relates to diamond heatsink assemblies which are particularly suitable for mounting small electronic devices thereon which emit a fair degree of heat.

It is known to provide a diamond as a heatsink for such devices since the thermal conductivity of a diamond mounted on a suitable metal member of high thermal conductivity is at least twice that of a metal member without the diamond. The metal member usually comprises a threaded stud of gold, silver or copper with the diamond pressed into the end or the diamond may be mounted on top of the stud by soldering, brazing or welding. The stud is adapted to be screwed into a base or wall member until the end of the stud is substantially aligned with the surface of the base or wall member with the electronic device mounted centrally on the diamond. The electronic device may, for example project into a waveguide.

Typical prior diamond heatsink assemblies are disclosed in US—A—3 974 518 and US—A—3 872 496. US—A—3 974 518 has an integrated chip secured by an insulating member to a diamond element embedded in a thermally conductive substrate. US—A—3 872 496 has an electronic device arranged to be in thermal contact through layers of conductive metals to an irregular diamond partially embedded in a conductive substrate.

Problems with these arrangements are that the electronic device cannot be independently rotated on the stud to align the electronic device at a particular angle and that an all threaded stud has poor electrical and thermal contact with the base or wall member because of the small area of actual contact between the screw threads. The threaded stud must also be completely replaced if the electronic device becomes faulty.

Pressing the diamond into the heatsink has several disadvantages in that the diamond may fall out of the stud during severe environmental trials unless elaborate techniques such as high temperature brazing or the use of solder preforms are employed. The diamond-metal surface after pressing may not be very flat leading to problems with electrical continuity and the ability to mount other components, such as insulating stand-offs and the electronic device itself. There is also a possibility that the diamond may fracture when it is pressed into the stud.

When the diamond is mounted on top of the stud the electronic device is no longer in a mechanically equivalent position to that of the metal heatsink. This can lead to undesirable parasitic impedances in microwave and millimetric wave devices. Although the effect can sometimes be used to advantage, it is common practice that a diamond heatsink device is developed from a lower cost metal heatsink technology device and electrical equivalence may be important.

The diamond-to-metal bond relies on the contact at one surface, and since the electronic device is likely to be temperature cycled or undergo extreme temperature changes, this bond may be overstressed by differential thermal expansion effects, made more severe by the large (0.5—1 mm diameter) diamond.

It is an object of the present invention to provide a diamond heatsink assembly which will eliminate or reduce at least some of these problems.

According to an aspect of the present invention a diamond heatsink assembly comprises a diamond mounted on an electronic component mounting member, the diamond having a base, a mounting surface and at least one sidewall, the at least one sidewall being inclined to the base whereby the area of the mounting surface is less than the area of the base, and a clamping member having an orifice of identical shape to the diamond for surrounding and contacting the diamond on the full area of the sidewall or sidewalls of the diamond, the clamping member being adapted to be secured to the mounting member, at least one of the clamping member and the mounting member being formed of a high thermal conductivity metal.

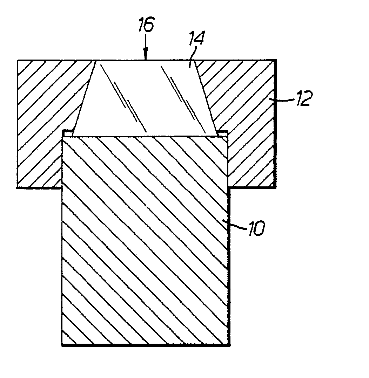

Further aspects of the invention will become apparent from the following description of an embodiment of the invention with reference to the accompanying drawing which is a cross-sectional view of a diamond heatsink assembly constructed in accordance with the invention.

The heatsink assembly comprises a mounting member 10 and a clamping member 12. These are made of metal, at least one of which must be a high thermal conductivity metal such as gold, silver, copper or aluminium. The parts 10 and 12 may be plated with another metal to reduce electrical skin resistance, offer environmental protection or for good soldering. The clamping member 12 may be made by turning on a lathe or parting from rod and then a conical hole is produced by machining or spark erosion. The mounting member may be turned or parted from rod. The diamond 14 is a frusto-conical shape and may be produced by conventional techniques, with the conical edge provided by a laser. The top face 16, must be lapped and polished. The diamond may have a thin layer of metal (typically 1 micron) on the top face only or on all faces, or the metallisation for electrical continuity may be applied by evaporation or sputtering to the complete construction after assembly. The diamond is held in place on the mounting member 10 by the clamping member 12 giving good thermal contact between the diamond and both metal parts. The assembly of the mounting member 10 to the clamping member 12 may be by one of several methods:

(i) If the diamond has been metallised on the lower face, the mounting member 10 may be soldered to the clamping member and to the diamond,

(ii) The clamping member and the mounting member may be threaded and the two screwed together,

(iii) The mounting member 10 may be press fitted to the clamping member 12,

(iv) The mounting member 10 may be friction welded or soldered to the clamping member 12,

(v) The mounting member may be fitted to the clamping member utilising differential thermal expansion, e.g. by freezing the mounting member in liquid nitrogen for an easy fit to the clamping member.

The heatsink assembly may allow the top of the diamond to stand proud of the package surface.

The mounting member 10 may extend beyond the base of the clamping member 12 as shown in the drawing to provide convenient mounting to a collet, or it may remain flush with the base of the clamping member 12.

The semiconductor device is mounted on the top face 16 of the diamond, and insulating rings or stand-offs may be mounted on the clamping member 12 or the diamond 14 or partly on the clamping member and the diamond.

Instead of having a frusto-conical shape the diamond could be formed with a truncated pyramid with a three or more sided base.

## Claims

1. A diamond heatsink assembly comprising a diamond (14) mounted on a mounting member (10), the diamond (14) having a base, an electronic component mounting surface (16) and at least one sidewall, the at least one sidewall being inclined to the base whereby the area of the mounting surface (16) is less than the area of the base, and a clamping member (12) having an orifice of identical shape to the diamond (14) for surrounding and contacting the diamond (14) on the full area of the sidewall or sidewalls of the diamond (14), the clamping member (12) being adapted to be secured to the mounting member (10) and at least one of the clamping member and the mounting member (10) being formed of a high thermal conductivity metal.

2. A diamond heatsink assembly as claimed in claim 1 in which the diamond (14) has one, two or three of its sidewalls inclined to the base.

3. A diamond heatsink assembly as claimed in claim 1 or claim 2 in which the diamond (14) has a truncated pyramid shape.

4. A diamond heatsink assembly as claimed in claim 1 or 2 in which the diamond (14) has a frusto-conical shape.

5. A diamond heatsink assembly as claimed in any preceding claim in which the diamond (14) is coated on at least one of its surfaces with a layer of metal.

6. A diamond heatsink assembly as claimed in claim 5 in which the layer of metal is selected from the group comprising of gold, silver, copper and aluminium.

7. A diamond heatsink assembly as claimed in claim 5 or claim 6 in which the layer of metal is applied by evaporation or sputtering techniques.

8. A diamond heatsink assembly as claimed in any preceding claim in which at least one of the clamping (12) member and the mounting member (10) are formed from a metal selected from the group comprising gold, silver, copper and aluminium.

9. A diamond heatsink assembly as claimed in claim 8 in which the surface of the clamping and mounting members (12, 10) are plated with a layer of metal to reduce electrical skin resistance.

## Patentansprüche

1. Eine Diamanten-Wärmesenkeneinheit bestehend aus einem Diamanten (14) befestigt auf einem Träger (10), wobei der Diamant (14) eine Unterfläche, eine Befestigungsfläche (16) für ein elektronischens Bauteil (16) und mindestens eine Seitenfläche besitzt, welche mindestens eine Seitenfläche gegen die Unterfläche geneigt ist, wodurch die Fläche der Befestigungsfläche (16) kleiner als die Unterfläche ist, und ein Klemmteil (12) welches eine dem Diamanten (14) identische Bohrung besitzt um den Diamanten (14) an der gesamten Fläche der Seitenwand oder Seitenwände des Diamanten (14) zu umgeben und zu kontaktieren, wobei das Klemmteil (12) dazu geeignet ist, an dem Befestigungsteil (10) befestigt zu werden und wobei mindestens eines des Klemmteiles und des Trägers (10) aus gut wärmeleitendem Metall besteht.

2. Eine Diamantenwärmesenkeneinheit nach Anspruch 1, wobei eine, zwei oder drei der Seitenwände des Diamanten (14) gegen die Unterfläche geneigt sind.

3. Eine Diamanten-Wärmesenkeneinheit nach Ansprüchen 1 oder 2, wobei der Diamant (14) eine abgestumpfte Pyramidenform hat.

4. Eine Diamanten-Wärmesenkeneinheit nach irgend einem der vorhergehenden Ansprüche, wobei der Diamant (14) eine abgestumpfte Frustro-Kegelform besitzt.

5. Eine Diamanten-Wärmesenkeneinheit nach irgend einem der vorhergehenden Ansprüche wobei der Diamant (14) mindestens an einer seiner Oberflächen mit einer Metallschichte bedeckt ist.

6. Eine Diamanten-Wärmesenkeneinheit nach Anspruch 5 wobei die Metallschichte von der aus Gold, Silber, Kupfer und Aluminium bestehenden Gruppe ausgewählt ist.

7. Eine Diamanten-Wärmesenkeneinheit nach Ansprüchen 5 oder 6 wobei die Metallschichte durch Verdampfungs- oder Spluttermethoden angebracht ist.

8. Eine Diamanten-Wärmesenkeneinheit nach irgend einem der vorhergehenden Ansprüche wobei mindestens eines der Klemmteile (12) und des Trägers (10) aus einem Metall welches von der aus Gold, Silber, Kupfer und Aluminium bestehenden Gruppe ausgewählt ist, besteht.

9. Eine Diamanten-Wärmesenkeneinheit nach Anspruch 8 wobei die Oberflächen der Klemmteile (12, 10) mit einer Metallschichte plattiert sind, um elektrischen Oberflächenwiderstand zu verkleinern.

## Revendications

1. Dissipateur de chaleur à diamant comprenant un diamant (14) monté sur un organe (10) de montage, le diamant (14) ayant une base, une surface (16) de montage d'un composant électronique et au moins une paroi latérale, la paroi latérale au moins étant inclinée par rapport à la base si bien que l'aire de la surface (16) de montage est inférieure à celle de la base, et un organe (12) de serrage ayant un orifice de forme identique à celle du diamant (14) et destiné à entourer le diamant (14) et à être à son contact sur toute l'étendue de la paroi latérale ou des parois latérales du diamant (14), l'organe de serrage (12) étant destiné à être fixé à l'organe de montage (10) et l'un au moins de l'organe de serrage et de l'organe de montage (10) étant formé d'un métal ayant une conductibilité thermique élevée.

2. Dissipateur de chaleur à diamant selon la revendication 1, dans lequel le diamant (14) a une, deux ou trois de ses parois latérales inclinées par rapport à la base.

3. Dissipateur de chaleur à diamant selon l'une des revendications 1 et 2, dans lequel le diamant (14) a la forme d'une pyramide tronquée.

4. Dissipateur de chaleur à diamant selon l'une des revendications 1 et 2, dans lequel le diamant (14) a une forme tronconique.

5. Dissipateur de chaleur à diamant selon l'une quelconque des revendications précédentes, dans lequel le diamant (14) est revêtu sur l'une au moins de ses faces d'une couche d'un métal.

6. Dissipateur de chaleur à diamant selon la revendication 5, dans lequel la couche de métal est choisie dans le groupe qui comprend l'or, l'argent, le cuivre et l'aluminium.

7. Dissipateur de chaleur à diamant selon l'une des revendications 5 et 6, dans lequel la couche de métal est appliquée par des techniques d'évaporation ou de pulvérisation cathodique.

8. Dissipateur de chaleur à diamant selon l'une quelconque des revendications précédentes, dans lequel l'un au moins des organes de serrage (12) et de montage (10) est formé d'un métal choisi dans le groupe qui comprend l'or, l'argent, le cuivre et l'aluminium.

9. Dissipateur de chaleur à diamant selon la revendication 8, dans lequel la surface des organes de serrage et de montage (12, 10) est revêtue d'une couche d'un métal afin que la résistance électrique pelliculaire soit réduite.